Europäisches Patentamt

European Patent Office

Office européen des brevets

(19)

(11)  EP 0 711 041 A1

## (12) EUROPEAN PATENT APPLICATION

(43) Date of publication:
08.05.1996  Bulletin 1996/19

(51) Int. Cl.$^6$: **H03L 7/14**, H03L 7/089

(21) Application number: 94830523.0

(22) Date of filing: 03.11.1994

(84) Designated Contracting States:
AT BE CH DE DK ES FR GB GR IE IT LI LU MC NL PT SE

(71) Applicant: SGS-THOMSON MICROELECTRONICS S.r.l.
I-20041 Agrate Brianza (Milano) (IT)

(72) Inventors:
• Gadducci, Paolo
  I-20010 Bareggio, Milano (IT)
• Demicheli, Marco
  I-22070 Binago, Como (IT)
• Pisati, Valerio
  I-27049 Bosnasco, Pavia (IT)
• Alini, Roberto
  I-27049 Stradella, Pavia (IT)

(74) Representative: Maggioni, Claudio et al
c/o JACOBACCI & PERANI S.p.A.
Via Visconti di Modrone, 7
I-20122 Milano (IT)

## (54) Phase-locked circuit

(57)    A phase-locked circuit for regulating the frequency of a controllable oscillator (ICO2) at a preset value is described. It comprises a reference oscillator (ICO1) which generates a signal at the preset frequency, a phase detector (10) which receives the signals from the two oscillators and produces a phase error signal, and processing circuit means which can apply a signal which is a function of the magnitude and sign of the phase error at the regulating terminal of the controllable oscillator (ICO2).

In order to enable the feedback loop to open for an indefinite period after a phase-locking while still maintain the frequency at the preset value, the processing circuit means comprise a counter (CNT) which numerically measures the phase error and a digital-to-analogue convertor (DAC) which produces an input signal corresponding to the numerical measurement.

FIG. 3

EP 0 711 041 A1

## Description

The present invention relates to circuits for regulating the frequency of an oscillator and, more particularly, to a phase-locked circuit for regulating the frequency of a controllable oscillator to a preset value by applying thereto a regulating signal at a suitable terminal.

As is known, a phase-locked circuit consists substantially of a reference oscillator which generates a signal having a frequency set stably at the desired value, of a phase detector which receives at its input the signals from the two oscillators and produces a phase error signal, and of a low-pass filter which extracts the continuous component from the phase error signal and applies it at suitable amplitude to the regulating terminal of the controllable oscillator. Suitable processing circuit means are provided for coupling information relating to the phase error sign to the regulating signal and, thus, in order to render the feedback loop stable. The low-pass filter comprises a capacitor which is charged at a voltage which is proportional to the phase error detected.

A circuit of this type is described, for example, in the publication "Mass Storage Handbook - Advanced Peripherals", Rev. 2, National Semiconductors, 1988, pages 9-36/9-39.

In some applications in which the electrical energy consumption has to be reduced as far as possible, the phase-locked loop is opened for periods which are long to a greater or lesser extent, deactivating the circuit components thereof as soon as coupling has occurred, that is, as soon as the steady operating conditions have been attained with the controllable oscillator operating exactly at the same frequency and with the same phase of the reference oscillator. In this case, maintaining the steady operating conditions for the desired period of time should be guaranteed by a sufficiently large capacitance of the low-pass filter capacitor. If it is desired to restrict the dimensions of the capacitor, for example when it is to be incorporated in an integrated circuit, the periods in which the phase-locked loop can be opened should of necessity be very short such that the saving in consumption is correspondingly reduced.

The object of the present invention is to produce a phase-locked circuit of the type indicated initially, in which, when the steady conditions have been reached, the feedback loop can be held open for a period of indefinite length.

In accordance with the invention this object is achieved by means of a phase-locked circuit as defined and characterized in general in the first of the claims following the present description.

The invention will be better understood from the following detailed description of one of its embodiments which is in no way limiting and is provided with reference to the appended drawings, in which:

- Figure 1 shows the basic operating diagram of a phase-locked circuit of known type;

- Figure 2 shows a series of wave forms relating to the operation of the known circuit of Figure 1;

- Figure 3 shows a basic diagram of the phase-locked circuit according to the invention; and

- Figure 4 shows a series of wave forms relating to the operation of the circuit of Figure 3.

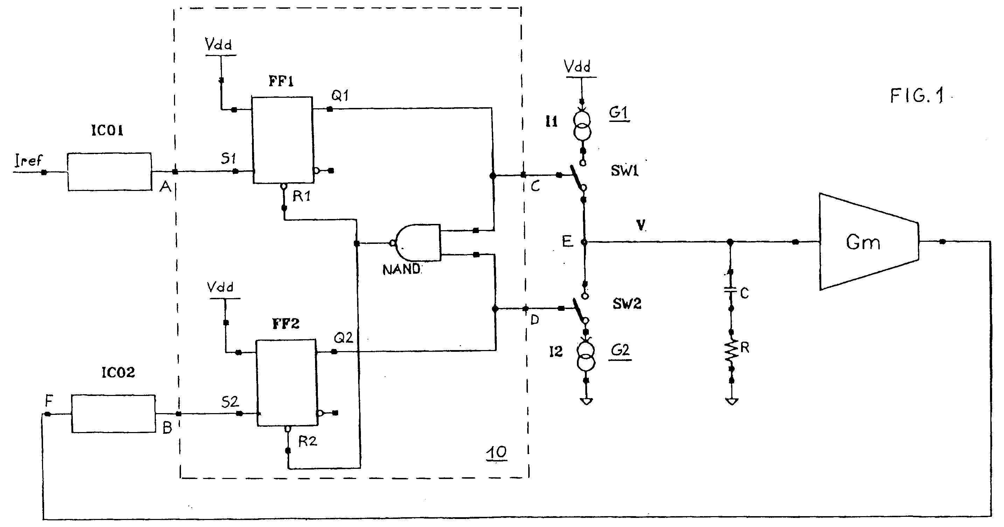

Figure 1 will be considered first of all.

A reference oscillator ICO1 and a control oscillator ICO2, both of the type which are controllable by a current, have their respective outputs connected to the inputs A and B of a phase detector, generally indicated 10. The reference oscillator ICO1 has a regulating input connected to a reference current generator Iref, not shown.

The phase detector 10 comprises two flip-flops FF1 and FF2, of which the "set" terminals S1 and S2 form the inputs A and B of the detector and of which the output terminals Q1 and Q2 are connected to the outputs C and D of the detector. A logic gate NAND has its two inputs connected to the outputs Q1 and Q2 of the flip-flops and the output connected to the "reset" terminals R1 and R2 of the flip-flops. The outputs C and D of the phase detector are also connected to the activating terminals of two constant current generators, represented in the drawing by a generator G1, connected in series to a switch SW1 between a power-supply terminal Vdd and a circuit node E, and by a generator G2 connected in series with a second switch SW2 between a second power-supply terminal, indicated by the earth symbol, and the same node E.

A low-pass filter formed by a capacitor C in series with a resistor R is connected between the node E and earth. The node E is also connected to a transconductance amplifier, indicated Gm, of which the output is connected to the regulating terminal F of the oscillator ICO2 to be controlled.

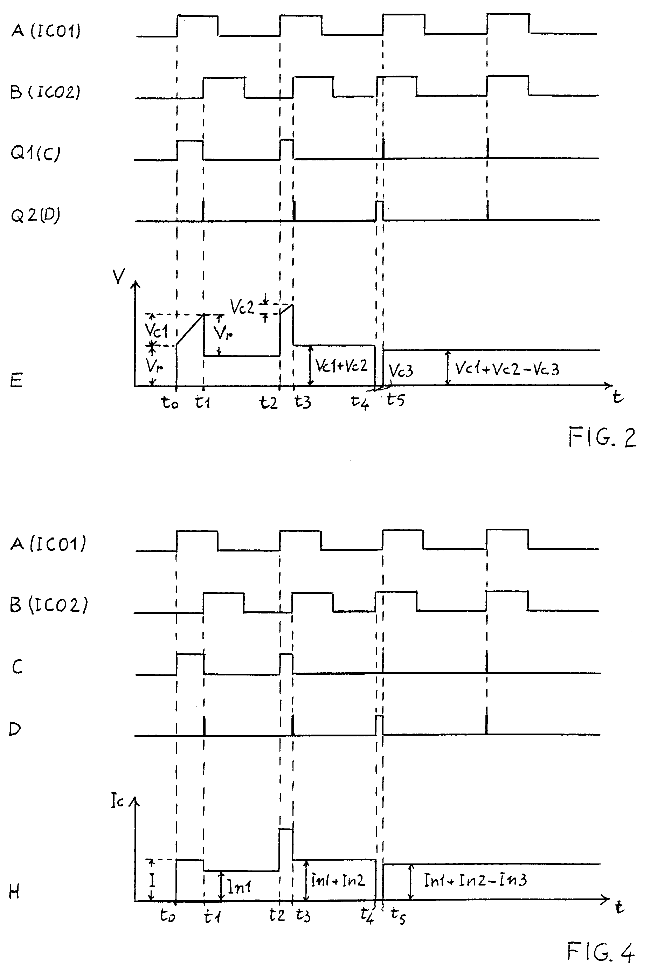

The operation of the circuit will now be considered with reference to Figure 2, assuming that, initially, the oscillator ICO2 is delayed relative to the reference oscillator ICO1, that the outputs Q1 and Q2 of the two flip-flops are at a low level and the capacitor C is discharged. At the instant $\underline{t_o}$, corresponding to the leading edge of the output signal ICO1, the flip-flop FF1 receives a switching signal and its output Q1 changes to the high level. At the instant $\underline{t_1}$, corresponding to the leading edge of the output signal of ICO2, the flip-flop FF2 also receives a switching signal and its output Q2 changes to the high level. Simultaneously, the gate NAND has both its inputs at the high level such that a signal appears at its output which causes both flip-flops to be reset. At the node E, at the instant $\underline{t_o}$, owing to the activation of the current generator G1 (closure of the switch SW1), a voltage $Vr = IR$ develops momentarily, in which I is the current of the generator G1 and R is the resistance of the resistor R to which is added the voltage $Vc_1 = I/C (t_1-t_o)$ due to the charge of the capacitor C in the time interval $t_1-t_o$ during which the generator G1 is activated. When the flip-flops are reset immediately after the instant t1, the outputs Q1 and Q2 return to the low level, the generator G1 is deactivated, the current I stops passing through the resistor R and the voltage V is reduced momentarily at the node E to the value Vc1 owing to the load accumulated at the capacitor in the time t1-to.

The voltage formed at the node E since the instant to is converted into current by the amplifier Gm and is applied at the regulating terminal F of the oscillator ICO2, causing a momentary frequency variation, that is in practice, a reduction of the phase error, i.e. of the phase-displacement between the two oscillators.

If the signal of ICO1 is still in advance relative to that of ICO2, as shown in Figure 2, the above process is repeated and the voltage V at the node E, which gives rise to the regulating signal of the oscillator ICO2, increases by a value Vc2 owing to a further charging of the capacitor C in the interval t3-t2 which corresponds to the phase-displacement still existing between the two oscillators. If the corresponding frequency correction of ICO2 leads to a delay of ICO1 relative to ICO2, as shown in the Figure, the process is repeated with the opposite sign, i.e. there is firstly a high level at the output Q2 of the flip-flop FF2 and the generator G2 is activated (switch SW2 closed). At the instant t4, corresponding to the leading edge of the output signal of ICO2, the voltage V at the node E decreases by the value IR, in which I is the current of the generator G2, which in this example is assumed to be equal to that of the generator G1, and then subsequently decreases by the value $Vc3 = I/C (t5-t4)$ owing to the discharge of the capacitor C in the interval t5 - t4 corresponding to the phase-displacement. Immediately after the instant t5, the voltage at the node E increases by the value $Vr = IR$ and reaches the value $V = Vc1 + Vc2 - Vc3$ .

In the example shown, it is assumed that, with the latter correction, the phase-locking of the controlled oscillator ICO2 to the reference oscillator ICO2 is completed. This situation remains until the regulating current at the terminal F of the oscillator ICO2 remains at the value corresponding to the final voltage $Vc1 + Vc2 - Vc3$ at the node E, even if the regulating loop is deactivated and thus open. As indicated above, the time during which the loop can remain open without influencing the correct frequency of the controlled oscillator depends on the dimensions of the capacitor C as well as, evidently, on the actual insulation of the capacitor itself whilst the circuit is open.

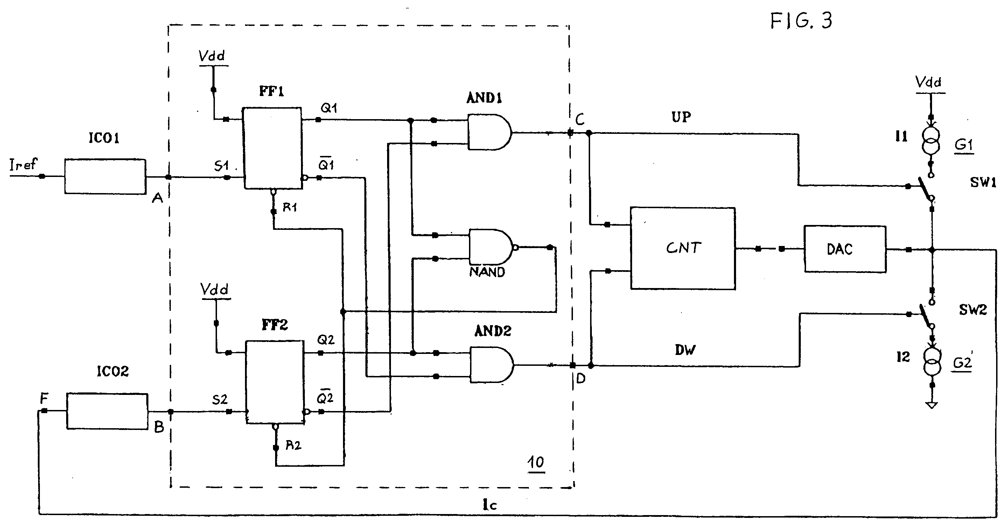

In Figure 3, in which components identical or equivalent to those of Figure 1 are designated by the same symbol or reference numeral, a phase-locked circuit according to the invention is shown. In addition to the two flip-flops FF1 and FF2 and the logic gate NAND, the phase detector 10 comprises two AND logic gates, designated AND1 and AND2, each having two inputs of which one is connected to the output, $\overline{Q1}$ or $\overline{Q2}$, of one of the two flip-flops, and the other to the inverted output, Q2 or Q1, of the other of the two flip-flops. As can easily be verified, the function of the two AND gates is to avoid there being a signal simultaneously at the two outputs of the detector 10.

In accordance with the invention the circuit processing the phase error signal produced by the detector 10 at its outputs C and D comprises an adding-subtracting counter, designated CNT, of which the adding input UP is connected to the output C and the subtracting input DW is connected to the output D, and a digital-to-analogue convertor, designated DAC, connected between the output of the counter CNT and the output node of the circuit, designated H, which is connected to the regulating terminal F of the oscillator ICO2.

The operation of the circuit of Figure 3 will now be considered with reference to the wave forms of Figure 4. It is assumed that the oscillator ICO2 to be controlled is also delayed in this case relative to the reference oscillator ICO1 and that the counter CNT is zeroed. At the instant to, the output C of the phase detector 10 changes to the high level whilst the output D is at the low level. At the instant t1 the situation is reversed and the flip-flops are reset by the NAND gate. Owing to the activation of the current generator G1, the current I of the generator G1, as a regulating current Ic, flows in the regulating terminal F during the interval t1-to. During this interval, the counter CNT is enabled to count in the adding direction owing to the presence of a high level signal at its input UP. The counting speed of the counter is selected such that it is high enough to obtain a measurement of the phase displacement with the desired degree of accuracy. The number n1 present at the output of the counter at the instant t1 is converted into a current In1, of which the magnitude is proportional to the phase displacement and which is sent to the regulating terminal F of the oscillator ICO2 until a new phase comparison is initiated at the instant t2.

The process is repeated in the measuring interval t3-t2 during which the adding counting terminal UP is activated once again. The counting of the counter passes from n1 to n2 and the regulating current Ic increases by a value In2 which is proportional to the new phase displacement measured. The following correction of the frequency of ICO2, in the example in question, leads to a delay of ICO1 relative to ICO2, as shown in Figure 4. Therefore, the process is repeated with an opposite sign, that is there is a low level at the output C and a high level at the output D of the phase detector, such that the generator G1 is deactivated and the generator G2 activated. At the same time the adding counting is deactivated and the subtracting counting of the counter CNT is activated.

At the instant t4 the current Ic decreases by the value I, that is by the current of the generator G2 which is assumed to be equal to that of G1, and at the instant t5, when G2 is deactivated, the current Ic is that which is determined by the new counting number of the counter. Since the counting was subtracting in the interval t5-t4 (in this example, the number subtracted is n3), the regulating current

$Ic = In1 + In2 - In3$ is reduced by a value proportional to this number which measures the phase-displacement t5-t4.

In the example illustrated in Figure 4 it is assumed that, with this regulating current, the phase-locking of the controlled oscillator ICO2 to the reference oscillator ICO1 is complete. This situation remains until the current Ic remains at the locking value. Since this current, in the circuit according to the invention, is determined by the content of a counter, it remains strictly constant for an indefinite period, thus ensuring that the frequency and the phase of the oscillator ICO2 are unchanged even when the components of the regulating circuit are deactivated, i.e. when the feedback circuit remains open.

Although only one embodiment of the invention has been illustrated and described it is clear that numerous variants and modifications are possible within the scope of the same inventive concept. For example, instead of being of the type operating at its own counting rate, independently of the inputs, as described, the counter could be of the type in which the counting pulses are the same as the input pulses. Furthermore, a counter which is insensitive to the simultaneous presence of two signals at its inputs could be provided instead of the logic circuit formed by the two logic gates AND1 and AND2 which prevents there being a signal simultaneously at the two outputs of the phase detector 10. In this case, however, the currents of the generators G1 and G2 would have to be equal so as not to have any effect on the regulating current when both generators are activated.

**Claims**

1. A phase-locked circuit for regulating the frequency of a controllable oscillator (ICO2) to a preset value, by applying a regulating signal at a regulating terminal (F) thereof, comprising:
   a reference oscillator (ICO1) which generates a signal at a frequency of the above preset value;
   a phase detector (10) which receives at an input thereof the signal generated by the controllable oscillator and the signal generated by the reference oscillator and produces at an output thereof a phase error signal;
   processing circuit means connected to the output of the phase detector (10) and to the regulating terminal (F) of the controllable oscillator (ICO2) which can generate at this terminal a regulating signal which is a function of the magnitude and sign of the phase error;
   characterised in that the processing circuit means comprise:
   a counter (CNT) which is activated by the output signal of the phase detector (10) in order to measure the phase error value numerically; and
   a digital-to-analogue convertor (DAC) connected between the counter (CNT) and the regulating terminal (F) which produces a signal of an amplitude corresponding to the above numerical measurement.

2. A circuit according to Claim 1, in which the processing circuit means comprise two constant and opposite signs current generators (G1, G2) connected to the regulating terminal (F) of the controllable oscillator (ICO2) and to the output of the phase detector (10) in order to be activated selectively by the latter as a function of the phase error sign.

3. A circuit according to Claim 1 or 2, in which the phase detector (10) comprises:
   a first flip-flop (FF1) having an input connected to the output (A) of the reference oscillator (ICO1) and an output (Q1) connected to a first output (C) of the detector and a second flip-flop (FF2) having an input (B) connected to the output of the controllable oscillator (ICO2) and an output (Q2) connected to a second output (D) of the detector (10), the magnitude of the phase error being defined by the time interval between the switching signals of the first and second flip-flops; and
   a logic circuit (NAND) having a first and a second input connected respectively to the outputs of the flip-flops and an output connected to respective "reset" inputs of the flip-flops and capable of generating a "reset" signal when both flip-flop output signals are present at the input of the logic circuit.

4. A circuit according to Claim 3, in which the counter (CNT) has a first, adding counting input (UP) and a second, subtracting counting input (DW) connected respectively to the first (C) and to the second (D) output of the detector (10) and in which a logic circuit (AND1, AND2) is provided which is coupled to the counter (CNT) and can enable the counter only when a switching signal is present at the output (Q1, Q2) of one or other of the flip-flops.

5. A circuit according to Claim 4, in which the logic circuit comprises a first AND gate (AND1) having a first input connected to the output (Q1) of the first flip-flop (FF1), a second input connected to the inverted output ($\overline{Q2}$) of the second flip-flop (FF2) and an output connected to the adding counting input (UP) of the counter (CNT) and a second AND gate (AND2) having a first input connected to the output (Q2) of the second flip-flop, a second input connected to the inverted output ($\overline{Q1}$) of the first flip-flop and an output connected to the subtracting counting input (DW) of the counter (CNT).

FIG.1

EP 0 711 041 A1

FIG. 2

FIG. 4

FIG. 3

EP 0 711 041 A1

**European Patent Office**

# EUROPEAN SEARCH REPORT

Application Number

EP 94 83 0523

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-4 988 955 (HORIE)<br>* column 7, line 33 - column 8, line 54; figures 6,7 *<br>--- | 1-3 | H03L7/14<br>H03L7/089 |
| X | DE-A-44 06 834 (MITSUBISHI DENKI K.K.)<br>* column 6, line 1 - column 12, line 56; figures 2,3,5-12 *<br>--- | 1,3 | |
| X | EP-A-0 585 806 (ALCATEL SEL AG)<br>* column 2, line 52 - column 6, line 19; figures *<br>--- | 1,3 | |
| A | IEEE JOURNAL OF SOLID-STATE CIRCUITS,<br>vol.24, no.2, April 1989, NEW YORK US<br>pages 325 - 330, XP69823<br>SAM YINSHANG SUN 'AN ANALOG PLL-BASED CLOCK AND DATA RECOVERY CIRCUIT WITH HIGH INPUT JITTER TOLERANCE'<br>* page 325, column 2, line 6 - line 33; figures 2,3 *<br>--- | 2,4,5 | |
| A | GB-A-2 055 268 (TOKYO SHIBAURA DENKI)<br>* page 1, line 3 - line 99; figures 1,8,9 *<br>----- | 4,5 | TECHNICAL FIELDS SEARCHED (Int.Cl.6)<br><br>H03L<br>H03D |

The present search report has been drawn up for all claims

| Place of search | Date of completion of the search | Examiner |
|---|---|---|
| THE HAGUE | 23 March 1995 | Balbinot, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document